Europäisches Patentamt

European Patent Office

Office européen des brevets

(11) Veröffentlichungsnummer: **0 1 1 9 489**
**B1**

(12) # EUROPÄISCHE PATENTSCHRIFT

(45) Veröffentlichungstag der Patentschrift:
01.06.88

(51) Int. Cl.⁴: **B 41 J 3/04,** G 01 D 15/18

(21) Anmeldenummer: 84101680.1

(22) Anmeldetag: 17.02.84

(54) **Mit Flüssigkeitströpfchen arbeitendes Schreibgerät.**

(30) Priorität: 22.02.83 DE 3306101

(43) Veröffentlichungstag der Anmeldung:
26.09.84 Patentblatt 84/39

(45) Bekanntmachung des Hinweises auf die Patenterteilung:
01.06.88 Patentblatt 88/22

(84) Benannte Vertragsstaaten:
DE FR GB IT

(56) Entgegenhaltungen:
EP - A - 0 062 889

(73) Patentinhaber: **Siemens Aktiengesellschaft Berlin und München, Wittelsbacherplatz 2, D-8000 München 2 (DE)**

(72) Erfinder: **Nilsson, Kenth, Dipl.-Ing., Traelhausvaegen 42, S-184 00 Akersberga (SE)**
Erfinder: **Bolmgren, Jan, Aengsullsvaegen 37, S-162 46 Vaellingby (SE)**

## Beschreibung

Die Erfindung betrifft ein mit Flüssigkeitströpfchen arbeitendes Schreibgerät zur punktweisen Aufzeichnung analoger Verläufe oder alphanumerischer Zeichen sowie von Bildern, wobei zum Schreiben der einzelnen Punkte reihenweise angeordnete Düsen vorhanden sind, vor deren Eintrittsöffnungen derart kontaktierte piezoelektrische Wandler angeordnet sind, dass bei elektrischen Spannungsänderungen an der Kontaktierung Schreibflüssigkeit aus der Düse herausgestossen und auf einem vor der Austrittsöffnung der Düsen angeordneten Aufzeichnungsträger aufgebracht wird, wobei die einzelnen Wandler durch die Zähne einer kammartigen Piezoplatte geformt werden und das Plattenmaterial selbst bilaminar aus Piezokeramik und einer Trägerschicht gebildet ist und wobei die Piezoplatte mittels einer Befestigungsanordnung, die auf den allen Zähnen gemeinsamen Kammrücken angebracht ist, in ihrer Lage gehalten wird.

Ein solches Schreibgerät, bei dem das Plattenmaterial aus Piezokeramik und Metall besteht, ist durch die EP-A 0 062 889 bekannt. Die Befestigungsanordnung, die als Klammer ausgebildet ist, verläuft über die gesamte Länge des Kammrückens der kammartigen Piezoplatte (im folgenden Kamm genannt). Das Problem bei dieser Konstruktion besteht darin, dass die Einspannung des Kammes in die Klammer mit extrem hoher Genauigkeit erfolgen muss. Da die Dicke des Kammes nur einige zehntel Millimeter beträgt, führt eine kleine Verschiebung der Klammer gegenüber dem Kamm zu unterschiedlichen Biegelängen der Wandler. Dies kann zu einer ungenauen Schrift führen.

Bei den herkömmlichen Kammeinspannungen muss zusätzlich noch berücksichtigt werden, dass die Klammer exakt und möglichst mit gleicher Kraft mit sämtlichen Wandlern des Kammes in Kontakt kommt, damit die Biegelänge aller Wandler gleich bleiben. Dies ist insbesondere bei den mittleren Wandlern des Kammes schwer zu erreichen, die daher dazu neigen, sich auch unterhalb der Klammer zu biegen.

Der Erfindung liegt die Aufgabe zugrunde, ein Schreibgerät der eingangs genannten Art zu schaffen, bei dem in einfacher Weise die Länge der Schwingungsteile der einzelnen Wandler genau festgelegt wird und Verspannungen vermieden werden.

Diese Aufgabe wird erfindungsgemäss dadurch gelöst, dass im Bereich des Kammrückens auf der Seite der Piezoplatte, die der Befestigungsanordnung zugewandt ist, die Piezokeramik mit einer Armierungsschicht versehen ist. Die Piezokeramik ist dadurch im Bereich des Kammrückens auf beiden Seiten mit einer Trägerschicht versehen. Die Abmessungen und Materialien der Trägerschichten sollen vorzugsweise so getroffen werden, dass sie der Ausdehnungskraft der Piezoschicht beim Einlegen einer Spannung auf beiden Seiten einen gleich grossen Widerstand entgegensetzen. Hierdurch wird erreicht, dass sich die Piezoschicht in dem armierten Bereich geradlinig ausdehnt und es nicht zu unerwünschten Verbiegungen kommt. Vorteilhaft ist dabei, dass als Klammer für den Kamm eine sehr viel einfachere Anordnung ohne Anforderungen an Toleranzen eingesetzt werden kann. Die genaue Länge der Schwingungsteile der Wandler ist die vordere Kante der Armierung festgelegt. Weitere Vorteile und Einzelheiten ergeben sich aus den Unteransprüchen.

Die Erfindung ist nachfolgend anhand eines in den Zeichnungen dargestellten Ausführungsbeispiels näher erläutert. Es zeigen:

Fig. 1 eine Draufsicht auf eine kammartige Piezoplatte nach der Erfindung,

Fig. 2 einen Schnitt durch eine Piezoplatte gemäss Schnittlinie II-II von Fig. 1,

Fig. 3 eine schematische Ansicht eines Schreibgerätes, und

Fig. 4 eine Seitenansicht eines als Biegeschwinger arbeitenden piezoelektrischen Wandlers.

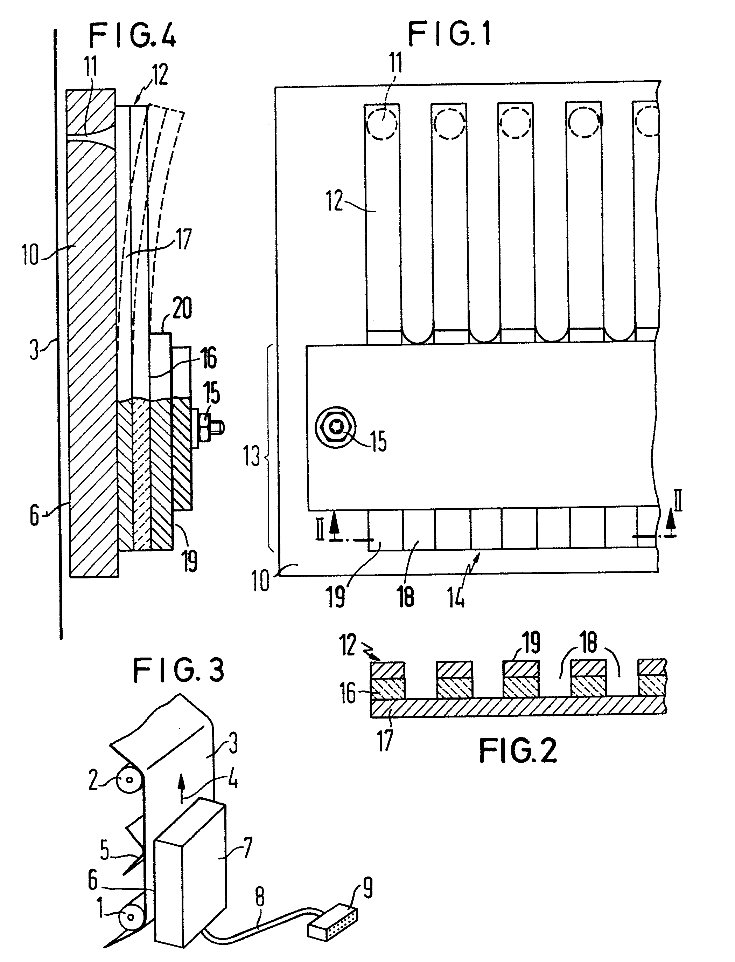

Aus Fig. 3 ist der äussere Prinzipaufbau eines Schreibgerätes ersichtlich. Über die Transportrollen 1 und 2 wird der Aufzeichnungsträger 3, z.B. normales Registrierpapier, in Richtung des Pfeiles 4 über einen Abstandshalter 5 an der Seite 6 des Gehäuses 7 vorbeigezogen. In das Gehäuse 7 ist die Anschlussleitung 8 geführt, die an ihrem freien Ende mit einem Stecker 9 zum Anschluss an ein nicht dargestelltes Steuergerät versehen ist, das die Steuersignale für die Aufzeichnung der gewünschten Verläufe, Zeichen oder Bilder liefert.

In Fig. 4 ist dargestellt, wie die Seite 6 des Gehäuses 7 parallel zum Aufzeichnungsträger 3 angebracht ist. Die Seite 6 ist die Seite eines Trägers 10, der eine Anzahl in einer Reihe nebeneinander angeordneter Düsen 11 aufweist. Ausser der Schreibflüssigkeit sind im Gehäuse 7 stabförmige Wandler 12 aus piezoelektrischem Material vorhanden, die derart kontaktiert und angeordnet sind, dass sie bei entsprechender elektrischer Ansteuerung Schreibflüssigkeit in Form eines Tröpfchens aus der Düse 11 spritzen.

Die Wandler 12, die als Zähne eines Kammes ausgebildet sind (Fig. 1), arbeiten als Biegeschwinger. Dabei ist der aus den Wandlern 12 und dem Kammrücken 13 bestehenden Piezokamm 14 parallel zur Ebene des Trägers 10 angeordnet. In der Fig. 4 ist dargestellt, dass die kammartige Piezoplatte bilaminar ist und aus einer Piezokeramik-Schicht 16 und einer Metallschicht 17 gebildet ist. Im Bereich des allen Zähnen gemeinsamen Kammrückens ist die Piezokeramikschicht 16 mit einer Armierungsschicht 19 versehen (Fig. 1). Die Lage der Kante 20 der Armierungsschicht 19 legt die Länge der Schwingungsteile der Wandler 12 fest. Für die Armierungsschicht 19 wird vorzugsweise das gleiche Material wie für die Trägerschicht 17, z.B. Nickel, verwendet, so dass die Elastizität der Anwendungsschicht 19, der der Trägerschicht 17 entspricht. Der freie Endbereich der einzelnen Wandler 12 befindet sich vor den einzelnen Düsen 11 der Düsenreihe. Der Kammrücken 13 ist mit einem Befestigungsschraubsatz 15 an dem die Düsenreihe aufnehmenden Träger 10 angeschraubt. Bei Anlegen von elektrischer Spannung an die Kontaktierung eines Wandlers 12 bewegt sich dieser in die Fig. 4 gestrichelt dargestellte Position. Bei Kurzschliessen eines Wandlers 12 schnellt er in die nicht gebogene, mit durchzogenen Linien gezeichnete Stellung zurück und drückt dabei ein Tröpfchen Schreibflüssigkeit durch die Düse 11.

In den Fig. 1 und 2 ist dargestellt, dass zwischen den Zähnen bzw. den Wandlern 12 über den allen Zähnen 12 gemeinsamen Kammsteg 13 die Keramikschicht 16 in der Verlängerung der Zahnzwischenräume 18 auch auf dem Kammsteg entfernt ist. Die Fig. 1 und 4 sind nicht massstäblich dargestellt. Der Abstand zwischen z.B. jeder Düse 11 bzw. jedem Zahn 12 beträgt etwa 250 μm.

Als Träger bzw. Armierungsmaterial für die Piezokeramik kann statt Metall auch Keramik oder Glas – z.B. Aluminiumoxid oder Silizium – vorgesehen sein.

## Patentansprüche

1. Mit Flüssigkeitströpfchen arbeitendes Schreibgerät zur punktweisen Aufzeichnung analoger Verläufe oder alphanumerischer Zeichen sowie von Bildern, wobei zum Schreiben der einzelnen Punkte reihenweise angeordnete Düsen (11) vorhanden sind, vor deren Eintrittsöffnungen derart kontaktierte piezoelektrische Wandler (12) angeordnet sind, dass bei elektrischen Spannungsänderungen an der Kontaktierung Schreibflüssigkeit aus der Düse herausgestossen und auf einem vor der Austritts- öffnung der Düsen angeordneten Aufzeichnungsträger (3) aufgebracht wird, wobei die einzelnen Wandler (12) durch die Zähne einer kammartigen Piezoplatte (14) geformt werden und das Plattenmaterial selbst bilaminar aus Piezokeramik (16) und einer Trägerschicht (17) gebildet ist und wobei die Piezoplatte mittels einer Befestigungsanordnung (15), die auf den allen Zähnen gemeinsamen Kammrücken (13) angebracht ist, in ihrer Lage gehalten wird, dadurch gekennzeichnet, dass im Bereich des Kammrückens (13) auf der Seite der Piezoplatte, die der Befestigungsanordnung zugewandt ist, die Piezokeramik (16) mit einer Armierungsschicht (19) versehen ist.

2. Schreibgerät nach Anspruch 1, dadurch gekennzeichnet, dass die Elastizität der Armierungsschicht (19) der der Trägerschicht (17) entspricht.

3. Schreibgerät nach Anspruch 1 oder 2, dadurch gekennzeichnet, dass für die Armierungsschicht (19) das gleiche Material wie für die Trägerschicht (17) verwendet wird.

4. Schreibgerät nach einem der Ansprüche 1 bis 3, dadurch gekennzeichnet, dass als Material für die Armierungs- und/oder Trägerschicht Metall, z.B. Nickel, vorgesehen ist.

5. Schreibgerät nach einem der Ansprüche 1 bis 3, dadurch gekennzeichnet, dass für die Armierungs- und/oder Trägerschicht ein nichtleitendes Material wie Keramik oder Glas, z.B. Aluminiumoxyd oder Silizium, vorgesehen ist.

## Claims

1. A recording instrument utilizing droplets of liquid for the dot-by-dot recording of analogue processes or alphanumeric characters as well as images, wherein jets (11) are arranged in rows to record the individual dots, and piezoeletric transducers (12) are arranged in front of the jet inlet openings and are connected in such a manner that when there are electrical voltage changes at the connection, recording liquid is ejected out of the jet and applied to a recording medium (3) arranged in front of the outlet opening of the jets, wherein the individual transducers (12) are formed by the teeth of a comb-like piezoelectric plate (14) and the plate material itself is formed of a bilaminate of a piezoelectric ceramic (16) and a substrate layer (17), and wherein the piezoelectric plate is held in place by means of a fastening arrangement (15) which is attached to the back of the comb (13) that is common to all the teeth, characterised in that the piezoelectric ceramic (16) is provided with a reinforcement layer (19) in the area of the back of the comb (13) on the side of the piezoelectric plate facing the fastening arrangement.

2. A recording instrument according to Claim 1, characterised in that the elasticity of the reinforcement layer (19) corresponds to that of the substrate layer (17).

3. A recording instrument according to Claim 1 or 2, characterised in that the same material is used for the reinforcement layer (19) as is used for the substate layer (17).

4. A recording instrument according to one of Claims 1 to 3, characterised in that metal, e.g. nickel, is provided as material for the reinforcement and/or substrate layer.

5. A recording instrument according to one of Claims 1 to 3, characterised in that a non-conducting material such as ceramic or glass, e.g. aluminium oxide or silicon, is provided for the reinforcement and/or substrate layer.

## Revendications

1. Appareil d'enregistrement opérant avec des gouttelettes de liquide et servant à enregistrer sous la forme de points des courbes analogiques ou des caractères alphanumériques ainsi que des images, et dans lequel pour l'enregistrement des points individuels, il est prévu des buses (11) disposées selon une rangée et à l'avant des ouvertures d'entrée desquelles se trouvent disposés des transducteurs piézoélectriques (12) qui sont raccordés par contact de telle manière que, dans le cas de variations de la tension électrique au niveau du contact, de l'encre est éjectée de la buse et est déposée sur un support d'enregistrement (3) disposé à l'avant de l'ouverture de sortie des buses, et dans lequel les différents transducteurs (12) sont formés par les dents d'une plaque piézoélectrique (14) en forme de peigne et le matériau même de la plaque est réalisé sous la forme d'un bilame comprenant une céramique piézoélectrique (16) et une couche de support (17), et dans lequel la plaque piézoélectrique est maintenue en position au moyen d'un dispositif de fixation (15), qui est déposé sur le dos (13) du peigne commun à toutes les dents, caractérisé par le fait que dans la zone du dos (13) du peigne, sur le côté de la plaque piézoélectrique qui est tournée vers le dispositif de fixation, la céramique piézoélectrique (16) est munie d'une couche d'armature (19).

2. Appareil d'enregistrement suivant la revendication 1, caractérisé par le fait que l'élasticité de la couche d'armature (19) correspond à celle de la couche de support (17).

3. Appareil d'enregistrement suivant la revendication 1 ou 2, caractérisé par le fait qu'on utilise, pour la couche d'armature (19), le même matériau que pour la couche de support (17).

4. Appareil d'enregistrement suivant l'une des revendications 1 à 3, caractérisé par le fait qu'il est prévu un métal, par exemple du nickel, comme matériau pour la couche d'armature et/ou la couche de support.

5. Appareil d'enregistrement suivant l'une des revendications 1 à 3, caractérisé par le fait qu'on prévoit un matériau non conducteur tel qu'une céramique ou du verre, par exemple de l'oxyde d'aluminium ou bien du silicium, pour la couche d'armature et/ou de support.

FIG.4

FIG.1

FIG.3

FIG.2